# EUROPÄISCHE PATENTSCHRIFT

(11) **EP 3 341 975 B1**
(45) Veröffentlichungstag und Bekanntmachung des Hinweises auf die Patenterteilung: **03.06.2020**
(21) Anmeldenummer: 16754243.0
(22) Anmeldetag: 10.08.2016
(51) Int. Cl.: H01L 33/00, H01L 33/50

(54) **VERFAHREN ZUR HERSTELLUNG VON LICHTEMITTIERENDEN HALBLEITERBAUTEILEN**
METHOD FOR PRODUCING LIGHT-EMITTING SEMICONDUCTOR COMPONENTS
PROCÉDÉ DE FABRICATION DE COMPOSANTS SEMICONDUCTEURS ÉLECTROLUMINESCENTS

(30) Priorität: 26.08.2015 DE 102015114175
(43) Veröffentlichungstag der Anmeldung: 04.07.2018
(73) Patentinhaber: OSRAM Opto Semiconductors GmbH, 93055 Regensburg (DE)
(72) Erfinder: O'BRIEN, David, Portland 97221 Oregon (US); GÖÖTZ, Britta, 93051 Regensburg (DE); VON MALM, Norwin, 93152 Nittendorf (DE)
(74) Vertreter: Epping - Hermann - Fischer
(86) Internationale Anmeldenummer: PCT/EP2016/069069
(87) Internationale Veröffentlichungsnummer: WO 2017/032605

(56) Entgegenhaltungen:
- WO-A1-2010/077226
- WO-A1-2011/053635
- WO-A2-2013/015532
- DE-A1-102012 103 393
- US-A1- 2010 110 728
- Anonymous: "Borosilicate glass", Wikipedia, the free encyclopedia , XP002763246, Gefunden im Internet: URL:https://en.wikipedia.org/wiki/Borosili cate_glass [gefunden am 2016-10-20]

## Beschreibung

Es wird ein Verfahren zur Herstellung von lichtemittierenden Halbleiterbauteilen angegeben.

Eine zu lösende Aufgabe besteht darin, ein Verfahren anzugeben, mit dem kompakte Konversionselemente für lichtemittierende Halbleiterbauteile effizient herstellbar sind.

Die Druckschrift WO 2011/053635 A1 betrifft eine LED, bei der einem LED-Chip als Leuchtstoff in einer Kapillare Quantenpunkte nachgeordnet sind.

Die Druckschrift WO 2013/015532 A2 betrifft eine LED, bei der ein Leuchtstoffelement einem LED-Chip nachgeordnet ist, wobei das Leuchtstoffelement eine Glaskapillare aufweist, die mit verschiedenen Leuchtstoffen gefüllt ist, und wobei die Glaskapillare zwischen einem Versieglungsbereich und dem mit Leuchtstoffen gefüllten Bereich ein Schutzgas aufweist.

Diese Aufgabe wird unter anderem durch ein Verfahren mit den Merkmalen des Patentanspruchs 1 gelöst. Bevorzugte Weiterbildungen sind Gegenstand der weiteren Ansprüche. Erfindungsgemäß wird mit dem Verfahren ein lichtemittierendes Halbleiterbauteil hergestellt. Bei dem lichtemittierenden Halbleiterbauteil handelt es sich um eine Leuchtdiode, kurz LED. Das lichtemittierende Halbleiterbauteil weist als Lichtquelle einen Leuchtdiodenchip auf.

Erfindungsgemäß weist das Verfahren den Schritt des Bereitstellens zumindest einer Glaskapillare auf. Die Glaskapillare ist aus einem Glasmaterial gebildet. Glaskapillare bedeutet insbesondere, dass die Glaskapillare röhrenförmig gestaltet ist. Ein Querschnitt der Glaskapillare kann dabei rechteckig oder rund sein.

Erfindungsgemäß wird die Glaskapillare mit mehreren Leuchtstoffen befüllt.

Erfindungsgemäß weist das Verfahren den Schritt des Versiegelns der Glaskapillare auf. Das Versiegeln erfolgt in einem Versiegelungsbereich. In dem Versiegelungsbereich ist die Glaskapillare somit verschlossen.

Gemäß zumindest einer Ausführungsform ist die Versiegelung der Glaskapillare eine hermetische Abdichtung. Insbesondere wird durch die Versiegelung eine Abdichtung gegen Feuchtigkeit und Sauerstoff erzielt. Diffusionskoeffizienten von Sauerstoff und Feuchtigkeit durch die Versiegelung hindurch sind dabei bevorzugt kleiner als die zugehörigen Diffusionskoeffizienten durch unbehandelte Außenwände der Glaskapillare hindurch. Insbesondere liegt eine mittlere Dicke der Versiegelung oberhalb einer mittleren Wandstärke der Außenwände der unbehandelten Glaskapillare.

Erfindungsgemäß erfolgt das Versiegeln durch ein Aufschmelzen oder zumindest Erweichen des Glasmaterials der Glaskapillare. Somit wird die Glaskapillare dann durch das Glasmaterial selbst verschlossen. Ein zusätzliches Versiegelungsmaterial ist in diesem Fall nicht erforderlich.

Erfindungsgemäß wird mindestens ein Teil der versiegelten Glaskapillare an wenigstens einen lichtemittierenden Halbleiterchip, der ein Leuchtdiodenchip ist, aufgebracht. Das Aufbringen ist beispielsweise ein Kleben. Alternativ ist es auch möglich, dass die Glaskapillare durch ein Anschmelzen des Glasmaterials an den lichtemittierenden Halbleiterchip angebracht wird.

Erfindungsgemäß wird in dem fertigen Halbleiterbauteil im Betrieb von dem Leuchtdiodenchip eine Primärstrahlung emittiert. Die Primärstrahlung wird durch die Leuchtstoffe teilweise oder vollständig in Licht einer größeren Wellenlänge, insbesondere in sichtbares Licht, umgewandelt. Somit ist durch die Leuchtstoffe ein Farbeindruck der von dem Halbleiterbauteil insgesamt emittierten Strahlung einstellbar.

Erfindungsgemäß liegt ein Abstand zwischen dem Versiegelungsbereich und den Leuchtstoffen beim und bevorzugt auch nach dem Versiegeln der Glaskapillare bei höchstens 4 mm oder 3 mm oder 1 mm. Mit anderen Worten erfolgt das Versiegeln nahe an den Leuchtstoffen.

Erfindungsgemäß ist das Verfahren zur Herstellung von lichtemittierenden Halbleiterbauteilen eingerichtet und umfasst die folgenden Schritte, bevorzugt in der angegebenen Reihenfolge:
A) Bereitstellen zumindest einer Glaskapillare aus einem Glasmaterial,
B) Befüllen der Glaskapillare mit mehreren Leuchtstoffen,
C) Versiegeln der Glaskapillare in einem Versiegelungsbereich durch Aufschmelzen und/oder Erweichen des Glasmaterials, so dass die Glaskapillare durch das Glasmaterial selbst verschlossen wird, wobei ein Abstand zwischen dem Versiegelungsbereich und den Leuchtstoffen bei höchstens 4 mm liegt, und
D) Anbringen mindestens eines Teils der versiegelten Glaskapillare an wenigstens einen lichtemittierenden Halbleiterchip, bei dem es sich um einen Leuchtdiodenchip handelt, so dass die im Betrieb von dem lichtemittierenden Halbleiterchip emittierte Strahlung durch die Leuchtstoffe teilweise oder vollständig in Strahlung einer größeren Wellenlänge, bevorzugt in sichtbares Licht, umgewandelt wird.

Bei herkömmlichen Leuchtstoffen für Leuchtdioden handelt es sich um anorganische, kristalline und/oder glasartige Materialien wie beispielsweise YAG:Ce. Eine Anzahl anderer Leuchtstoffklassen wie Quantenpunkte oder organische Leuchtstoffe versprechen jedoch viele Vorteile hinsichtlich ihrer optischen Eigenschaften gegenüber solchen herkömmlichen anorganischen Leuchtstoffen. Insbesondere weisen solche neueren Leuchtstoffe eine spektral schmalbandige Emission auf und eine Zentralwellenlänge der Leuchtstoffemission ist vergleichsweise leicht einstellbar.

Jedoch ist die Anwendbarkeit solcher neueren Leuchtstoffklassen für Lichtquellen mit einer hohen Lebensdauer bislang stark limitiert, da derartige Leuchtstoffe üblicherweise eine hohe Empfindlichkeit gegenüber Feuchtigkeit, Sauerstoff und Temperatureinwirkung aufzeigen. Daher sind solche Leuchtstoffe, insbesondere Quantenpunkte, in einer qualitativ hochwertigen Verkapselung unterzubringen, um den Leuchtstoff langfristig vor Umwelteinflüssen zu schützen. Eine solche Verkapselung des Leuchtstoffs ist jedoch schwierig mit herkömmlichen Verkapselungsmethoden, wie in der Leuchtdiodentechnik angewandt. Eine herkömmliche Verkapselungsmethode besteht darin, einen Leuchtstoff in eine Silikonmatrix oder eine Epoxidmatrix einzubetten.

Bei ungeeigneter Verkapselung jedoch erfolgt eine schwerwiegende Degradation solcher Leuchtstoffe und damit eine erhebliche Reduzierung der Lebensdauer des Leuchtstoffs und somit auch des Bauteils, in dem der Leuchtstoff verwendet wird. Zudem sind bei herkömmlichen Versiegelungsmethoden, mit denen eine qualitativ hochwertige Verkapselung erzeugt wird, üblicherweise hohe Temperaturen erforderlich, die einen solchen Leuchtstoff bereits beim Erzeugen der Verkapselung stark beeinträchtigen oder zerstören können.

Mit dem hier beschriebenen Verfahren ist es möglich, temperaturempfindliche Leuchtstoffe in Kapillaren aus einem Glas hochqualitativ zu versiegeln. Dabei sind sehr kompakte Konversionselemente erzielbar.

Andere Möglichkeiten, Leuchtstoffe zu versiegeln, bestehen darin, Leuchtstoffe in Glasgefäßen zu verkapseln. Solche Glasgefäße weisen jedoch vergleichsweise große geometrische Abmessungen auf und sind daher in Verbindung mit dem Aufbau von Leuchtdioden nur eingeschränkt geeignet. Eine weitere Möglichkeit zur Versiegelung von Leuchtstoffen besteht darin, diesen zwischen Polymerfolien, die mit einem anorganischen Material beschichtet sind, einzubetten. Jedoch sind die Kanten solcher Folien üblicherweise ungeschützt, was zu einer signifikanten Degradation des Leuchtstoffs über die Zeit hinweg führen kann. Durch die Eindiffusion von Feuchtigkeit oder Sauerstoff über einen Rand oder über Kanten der Folie hinweg sind auch minimale Abmessungen solcher Folien relativ groß.

Gemäß zumindest einer Ausführungsform des Verfahrens ist die Glaskapillare derart gestaltet, so dass zum Versiegeln und zum Aufschmelzen und/oder Erweichen des Glasmaterials nur eine vergleichsweise geringe Wärmemenge erforderlich ist. Dies ist insbesondere erreichbar durch kleine mittlere Wandstärken der Glaskapillare.

Gemäß zumindest einer Ausführungsform weist die Glaskapillare vor dem Schritt C) eine mittlere Wandstärke von höchstens 125 µm oder 100 µm oder 80 µm oder 55 µm auf. Alternativ oder zusätzlich liegt die mittlere Wandstärke bei mindestens 20 µm oder 40 µm. Mit anderen Worten kann es sich bei der Glaskapillare dann um einen Glashohldraht handeln. Aufgrund der geringen mittleren Wandstärke ist es möglich, dass die Glaskapillare, ähnlich einem Lichtwellenleiter, mechanisch flexibel und biegbar ist, beispielsweise mit Krümmungsradien von 10 cm oder weniger oder von 5 cm oder weniger. Bevorzugt weist die Glaskapillare vor dem Schritt C) eine durchweg konstante Wandstärke auf und somit ohne signifikante Dickenschwankungen.

Gemäß zumindest einer Ausführungsform liegt eine Dauer des Verfahrensschritts C) pro Versiegelungsbereich bei höchstens 6 s oder 4 s oder 2 s. Alternativ oder zusätzlich liegt diese Dauer pro Versiegelungsbereich bei mindestens 0,2 s oder 0,5 s oder 1 s. Dabei ist es möglich, dass mehrere Versiegelungsbereiche parallel durch Aufschmelzen oder Erweichen erzeugt werden. Durch diese geringe Verarbeitungsdauer ist eine thermische Belastung der Leuchtstoffe nur gering.

Erfindungsgemäß befinden sich im Verfahrensschritt B) die Leuchtstoffe in einem flüssigen Zustand. Dies kann bedeuten, dass die Leuchtstoffe selbst aufgeschmolzen oder flüssig sind oder dass die Leuchtstoffe in einem flüssigen Matrixmaterial eingebettet sind oder in einem Lösungsmittel vorliegen. Die die Leuchtstoffe bildende Flüssigkeit oder die die Leuchtstoffe umfassende Flüssigkeit wird dann in die Glaskapillare eingebracht.

Gemäß zumindest einer Ausführungsform erfolgt nach dem Schritt B) ein Verfestigen der Leuchtstoffe und/oder des Matrixmaterials, in das die Leuchtstoffe eingebettet sind. Bevorzugt erfolgt das Verfestigen photochemisch oder durch einen Trocknungsprozess. Beispielsweise wird das Matrixmaterial mit ultravioletter Strahlung photochemisch ausgehärtet. Ebenso ist es möglich, dass das Härten thermisch erfolgt. Bei dem Matrixmaterial handelt es sich zum Beispiel um ein Acrylat, ein Ormocer, ein Silikon, ein Epoxid oder ein Hybridmaterial. Ormocere sind etwa in der Druckschrift WO 2013/156325 A1 beschrieben. Der Offenbarungsgehalt dieser Druckschrift hinsichtlich der Ormocere wird durch Rückbezug mit aufgenommen.

Gemäß zumindest einer Ausführungsform weist das Matrixmaterial oder die flüssigen Leuchtstoffe im Schritt B) einen Kontaktwinkel zu der Glaskapillare auf, der bei mindestens 55° oder 65° oder 75° oder 85° liegt. Alternativ oder zusätzlich liegt der Kontaktwinkel bei höchstens 120° oder 105° oder 95°. Mit anderen Worten werden das Matrixmaterial und das Glasmaterial derart aufeinander abgestimmt, so dass Kontaktwinkel aufgrund der Oberflächenspannung der Leuchtstoffe und/oder des Matrixmaterials ungefähr 90° betragen.

Gemäß zumindest einer Ausführungsform liegt ein Quotient aus einer Länge der Glaskapillare und einem Durchmesser der Glaskapillare in dem fertigen Halbleiterbauteil und/oder im Schritt D) bei mindestens 15 oder 20 oder 25. Alternativ oder zusätzlich liegt dieser Quotient bei höchstens 150 oder 100 oder 70.

Erfindungsgemäß werden die in Form einer Flüssigkeit vorliegenden Leuchtstoffe mit einer Spritze in die Glaskapillare eingespritzt. Dabei bewegt sich bevorzugt die Spritze entlang einer Längsachse der Glaskapillare, um die Leuchtstoffe entlang der Glaskapillare gezielt zu verteilen.

Erfindungsgemäß befinden sich in der Glaskapillare nach dem Schritt B) abwechselnd mit den Leuchtstoffen gefüllte Bereiche und mit einem Schutzgas gefüllte Bereiche. Die verschiedenen Bereiche folgen bevorzugt entlang der Längsachse abwechselnd aufeinander. Bei dem Schutzgas handelt es sich beispielsweise um Stickstoff oder um Argon. In den mit dem Schutzgas gefüllten Bereichen liegt bei Raumtemperatur bevorzugt Normaldruck vor.

Gemäß zumindest einer Ausführungsform handelt es sich bei dem Glasmaterial um ein Borsilikatglas. Borsilikatglas kann bedeuten, dass ein Masseanteil von Siliziumdioxid an dem Glasmaterial mindestens 70 % beträgt und ein Masseanteil von Bortrioxid mindestens 7 %. Mit anderen Worten handelt es sich bei dem Glasmaterial dann um ein chemikalienbeständiges Glas mit einer vergleichsweise hohen Verarbeitungstemperatur.

Gemäß zumindest einer Ausführungsform liegt die Verarbeitungstemperatur des Glasmaterials im Schritt C) bei mindestens 500 °C oder 600 °C. Alternativ oder zusätzlich liegt die Verarbeitungstemperatur bei höchstens 900 °C oder 800 °C oder 700 °C. Bei der Verarbeitungstemperatur kann es sich um eine Schmelztemperatur oder eine Glasübergangstemperatur des Glasmaterials handeln. Aufgrund der vergleichsweise hohen Verarbeitungstemperatur handelt es sich bei dem Glasmaterial insbesondere um kein Glaslot. Gemäß zumindest einer Ausführungsform handelt es sich bei dem dem Glasmaterial um ein niederschmelzendes Glas. Eine Verarbeitungstemperatur des Glasmaterials im Schritt C) liegt in diesem Fall bei mindestens 200 °C und/oder bei höchstens 500 °C.

Gemäß zumindest einer Ausführungsform bleibt im Schritt C) die Glaskapillare als eine mechanische Einheit erhalten. Mit anderen Worten wird dann die Glaskapillare durch das Versiegeln nicht in einzelne Abschnitte zerteilt. Insbesondere kann die Glaskapillare eine mechanisch selbsttragende Einheit bleiben, so dass durch die Versiegelungsbereiche ein mechanischer Zusammenhalt der Glaskapillare nicht oder nicht signifikant beeinträchtigt ist. Insbesondere erfolgt in Schritt C) kein Vereinzeln oder Abschmelzen. Alternativ hierzu kann im Schritt C) sowohl ein Versiegeln als auch ein Vereinzeln erfolgen.

Gemäß zumindest einer Ausführungsform weist die Glaskapillare, zumindest vor dem Schritt C), einen Innenraum auf, dessen mittlere Querschnittsfläche, insbesondere in Richtung senkrecht zur Längsachse, bei mindestens 0,2 mm x 0,3 mm oder 0,3 mm x 0,4 mm und/oder bei höchstens 3 mm x 1,5 mm oder 2 mm x 1 mm oder 1,5 mm x 0,8 mm oder 1,2 mm x 0,6 mm liegt. Die Querschnittsfläche beträgt insbesondere weniger als 4,5 mm² oder 3 mm² oder 1 mm² und/oder mindestens 0,02 mm² oder 0,1 mm² oder 0,5 mm².

Gemäß zumindest einer Ausführungsform ist die Querschnittsfläche des Innenraums ein Rechteck oder ein Rechteck mit abgerundeten Ecken. Alternativ kann diese Querschnittsfläche auch wie ein Kreis oder eine Ellipse geformt sein. Alternativ oder zusätzlich ist auch eine äußere Umrissfläche der Glaskapillare, im Querschnitt gesehen, ein Rechteck oder ein Rechteck mit abgerundeten Ecken oder auch ein Halbkreis. Bevorzugt weist der äußere Umriss der Glaskapillare, im Querschnitt gesehen, zumindest eine gerade verlaufende Begrenzungslinie auf, an der der zumindest eine lichtemittierende Halbleiterchip anbringbar ist.

Gemäß zumindest einer Ausführungsform erfolgt das Aufschmelzen oder Erweichen des Glasmaterials im Schritt C) mit zumindest einem externen, außerhalb der Glaskapillare liegenden elektrischen Heizdraht. Durch einen solchen Heizdraht wird insbesondere ein Ring gebildet, durch den hindurch die Glaskapillare geführt wird. Jeweils in den Versiegelungsbereichen wird der Heizdraht aufgeheizt und damit die Verarbeitbarkeit des Glasmaterials bewirkt.

Alternativ zu einem Heizdraht kann das Erzeugen des Versiegelungsbereichs auch durch eine Flamme, etwa durch eine Gasflamme, oder durch Laserstrahlung erfolgen. Insbesondere wird im Falle von Laserstrahlung nahinfrarote Laserstrahlung eingesetzt. Weiterhin alternativ ist es möglich, dass bereits die Glaskapillare selbst mit einem Heizdraht versehen ist, der in den späteren Versiegelungsbereichen angebracht ist. Ein solcher Heizdraht der Glaskapillare kann zum Beispiel in dem Glasmaterial eingebettet sein oder an Außenwänden der Glaskapillare aufgebracht sein.

Erfindungsgemäß werden im Schritt B) mehrere verschiedene Leuchtstoffe in die Glaskapillare eingebracht. Dabei liegen die Leuchtstoffe, entlang der Längsachse der Glaskapillare, bevorzugt voneinander getrennt vor. Die verschiedenen Leuchtstoffe können durch einen Zwischenraum, insbesondere gefüllt mit dem Schutzgas, voneinander separiert sein. Die verschiedenen Leuchtstoffe sind beispielsweise dazu eingerichtet, aus der Strahlung des Leuchtdiodenchips unterschiedlich farbiges Licht zu erzeugen, beispielsweise blaues Licht, grünes Licht und/oder rotes Licht.

Gemäß zumindest einer Ausführungsform umfasst das Verfahren einen Schritt E). In dem Schritt E) wird die Glaskapillare zu Konversionselementen vereinzelt. Dieser Schritt E) folgt bevorzugt dem Schritt C) und/oder dem Schritt D) nach.

Gemäß zumindest einer Ausführungsform erfolgt das Vereinzeln im Schritt E) in den Versiegelungsbereichen. Dabei bleibt die Versiegelung bevorzugt beiderseits einer Trennlinie, entlang der die Vereinzelung erfolgt, intakt.

Gemäß zumindest einer Ausführungsform sind entlang der Längsachse mehrere der Versiegelungsbereiche vorhanden, , insbesondere zumindest drei oder zehn oder 20 Versiegelungsbereiche. Zwischen benachbarten Versiegelungsbereichen kann sich je ein Teil der in die Glaskapillare eingefüllten Leuchtstoffe befinden.

Gemäß zumindest einer Ausführungsform sind sowohl entlang der Längsrichtung als auch entlang einer Querachse mehrere der Vereinzelungsbereiche vorhanden sind. Die Querachse ist dabei bevorzugt senkrecht zur Längsachse orientiert. Somit liegt eine zweidimensionale Anordnung von Bereichen mit den Leuchtstoffen vor.

Gemäß zumindest einer Ausführungsform wird auf die zweidimensionale Anordnung von Leuchtstoffbereichen im Schritt D) ein zweidimensionales Feld von Leuchtdiodenchips aufgebracht. Die Leuchtdiodenchips können dabei einzeln aufgebracht werden oder, bevorzugt, im Verbund, sodass die Leuchtdiodenchips beispielsweise an einer Leiterplatte vormontiert sind.

Gemäß zumindest einer Ausführungsform wird im Schritt B) in die Glaskapillare zumindest ein Indikator für das Vorhandensein von Feuchtigkeit, Sauerstoff oder erhöhter Temperatur eingebracht. Alternativ kann dieses Einbringen bereits vor dem Schritt B) erfolgen. Über den Indikator ist feststellbar, ob in der Glaskapillare Feuchtigkeit vorliegt oder ob in die Glaskapillare Sauerstoff eingedrungen ist. Ebenso kann über einen Indikator überwacht werden, ob eine für die Leuchtstoffe zulässige Höchsttemperatur im Rahmen des Herstellungsverfahrens eingehalten wurde.

Gemäß zumindest einer Ausführungsform werden vor oder im Schritt B) in die Glaskapillare ein oder mehrere Einfangmaterialien eingebracht. Durch das mindestens eine Einfangmaterial ist bevorzugt Sauerstoff und/oder Feuchtigkeit adsorbierbar.

Gemäß zumindest einer Ausführungsform ist außen oder innen auf die Glaskapillare stellenweise eine lichtundurchlässige, bevorzugt reflektierende Beschichtung aufgebracht. Über eine solche Beschichtung ist eine Abstrahlcharakteristik von Licht aus der Glaskapillare heraus einstellbar.

Gemäß zumindest einer Ausführungsform ist die Glaskapillare zumindest bereichsweise als optisches Element geformt. Insbesondere ist die Glaskapillare als Sammellinse für das von den Leuchtstoffen emittierte Licht gestaltet.

Darüber hinaus wird ein lichtemittierendes Halbleiterbauteil angegeben. Das Halbleiterbauteil ist mit einem Verfahren hergestellt, wie in Verbindung mit einer oder mehrerer der oben genannten Ausführungsformen angegeben
Das Halbleiterbauteil umfasst zumindest einen Leuchtdiodenchip oder einen lichtemittierenden Halbleiterchip sowie zumindest eine Glaskapillare, in diesem Zusammenhang auch als Konversionselement bezeichnet. In die mindestens eine Glaskapillare sind zumindest zum Teil Leuchtstoffe gefüllt. Ein Abstand zwischen einem Versiegelungsbereich der Glaskapillare und den Leuchtstoffen beträgt dabei höchstens 4 mm oder höchstens 2 mm.

Gemäß zumindest einer Ausführungsform sind die Leuchtstoffe in der Glaskapillare dazu eingerichtet, blaues Licht in gelbes Licht umzuwandeln. Hierdurch ist es möglich, dass das Halbleiterbauteil im Betrieb mischfarbiges Licht, insbesondere weißes Licht, emittiert.

Gemäß zumindest einer Ausführungsform sind mehrere lichtemittierende Halbleiterchips, also Leuchtdiodenchips, vorhanden. Die Leuchtdiodenchips sind in einem geraden Streifen angeordnet und die Glaskapillare überdeckt den Streifen. Dabei ist bevorzugt jedem der Leuchtdiodenchips genau ein mit den Leuchtstoffen gefülltes Gebiet in der Glaskapillare zugeordnet. Benachbarte Leuchtstoffgebiete sind bevorzugt voneinander separiert und können optisch voneinander isoliert sein, beispielsweise durch ein in die Glaskapillare eingefülltes, lichtundurchlässiges Zwischenmaterial.

Gemäß zumindest einer Ausführungsform ist die Glaskapillare mechanisch fest mit dem Streifen verbunden. Beispielsweise ist die Glaskapillare auf dem Streifen mit den lichtemittierenden Halbleiterchips aufgeklebt oder mit dem Streifen verschmolzen.

Darüber hinaus wird ein Konversionselement angegeben. Das Konversionselement wird mit einem Verfahren hergestellt, wie in Verbindung mit einer oder mehrerer der oben genannten Ausführungsformen angegeben. Insbesondere handelt es sich bei dem Konversionselement um ein Bauteil, das dem lichtemittierenden Halbleiterbauteil ohne den zumindest einen Leuchtdiodenchip sowie ohne einem Verbindungsmittel zwischen dem Leuchtdiodenchip und der Glaskapillare entspricht. Mit anderen Worten handelt es sich bei dem Konversionselement um die mit Leuchtstoff befüllte, versiegelte und gegebenenfalls vereinzelte Glaskapillare.

Nachfolgend wird ein hier beschriebenes Verfahren unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Darstellung eines Ausführungsbeispiels eines Verfahrens zur Herstellung von lichtemittierenden Halbleiterbauteilen,
- Figur 2: eine schematische Darstellung eines Verfahren zur Herstellung von lichtemittierenden Halbleiterbauteilen, und
- Figuren 3 bis 7: schematische Darstellungen von Konversionselementen für lichtemittierende Halbleiterbauteile.

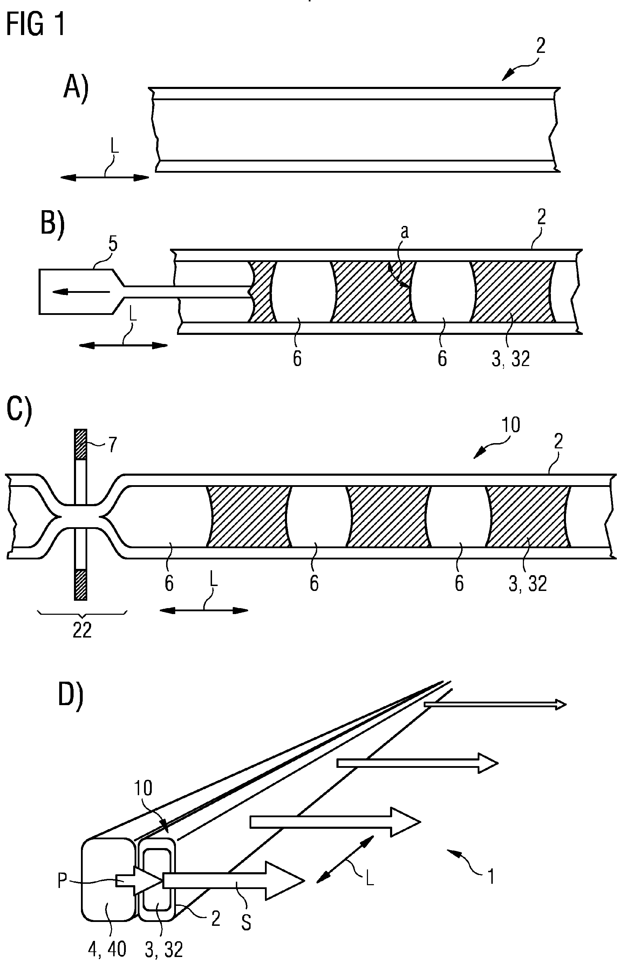

In Figur 1 ist ein Ausführungsbeispiel eines Herstellungsverfahrens für ein lichtemittierendes Halbleiterbauteil 1 illustriert, siehe die Schnittdarstellungen der Figuren 1A bis 1C und die perspektivische Darstellung in Figur 1D.

Gemäß Figur 1A wird eine Glaskapillare 2 bereitgestellt. Die Glaskapillare 2 ist röhrenförmig gestaltet mit einer Längsachse L, entlang der die Glaskapillare 2 die größte geometrische Ausdehnung aufweist. Im Querschnitt gesehen ist die Glaskapillare 2 rechteckig gestaltet, siehe auch Figur 1D. Eine Wandstärke der Glaskapillare 2 liegt unterhalb von 100 pm, beispielsweise bei 60 µm, und ist entlang der Längsachse L gleichbleibend. Eine innere Querschnittsfläche der Glaskapillare 2 beträgt beispielsweise ungefähr 1,5 mm², äußere Abmessungen der Glaskapillare 2 betragen zum Beispiel 1 mm x 2 mm.

Beim Verfahrensschritt, wie in Figur 1B illustriert, wird ein Leuchtstoff 3 in die Glaskapillare 2 eingebracht. Das Einbringen des Leuchtstoffs 3 erfolgt mit einer Spritze 5, die sich entlang der Längsachse L bewegt, um lokal gezielt den Leuchtstoff 3 einzubringen.

Bei dem Leuchtstoff 3 handelt es sich bevorzugt um Quantenpunkte, beispielsweise auf Basis von Cadmiumselenid oder Indiumphosphid. Die Quantenpunkte weisen bevorzugt einen mittleren Durchmesser von mindestens 3 nm oder 5 nm und/oder von höchstens 30 nm oder 15 nm auf. Der Leuchtstoff 3 liegt in einem Matrixmaterial 32 vor. Das Matrixmaterial 32 mit dem Leuchtstoff 3 wird in flüssiger Form in die Glaskapillare 2 eingebracht. Dabei füllt diese Flüssigkeit aus dem Matrixmaterial 32 und dem Leuchtstoff 3 den Querschnitt der Glaskapillare 2 stellenweise bevorzugt vollständig aus. Die Glaskapillare 2 ist insgesamt nur zum Teil von der Flüssigkeit gefüllt. Zwischen benachbarten Bereichen mit dem Leuchtstoff 3 befindet sich bevorzugt ein Schutzgas 6, beispielsweise Stickstoff.

Ein Kontaktwinkel a zwischen den Wänden der Glaskapillare 2 und dem noch flüssigen Matrixmaterial 32 liegt bei näherungsweise 90°. Hierdurch ist ein Ineinanderfließen benachbarter Bereiche mit dem Leuchtstoff 3 verhinderbar. Bei dem Matrixmaterial 32 handelt es sich beispielsweise um ein photochemisch härtbares Acrylat.

Anstelle von Quantenpunkten können auch andere Leuchtstoffe wie organische Leuchtstoffe, insbesondere in dem Matrixmaterial 32 gelöst, verwendet werden.

Nach dem Einbringen des Leuchtstoffs 3 wird das Matrixmaterial 32 ausgehärtet, nicht dargestellt. Das Aushärten erfolgt insbesondere durch Bestrahlung mit ultraviolettem Licht. Hierdurch ist eine thermische Belastung des Leuchtstoffs beim Aushärten vermeidbar.

Nachfolgend, siehe Figur 1C, wird ein Glasmaterial, aus dem die Glaskapillare 2 besteht, in einem Versiegelungsbereich 22 aufgeschmolzen oder zumindest erweicht. Das Aufschmelzen oder Erweichen erfolgt bevorzugt mittels eines Heizdrahts 7, durch den hindurch die Glaskapillare 2 geführt wird.

Aufgrund insbesondere der geringen Wandstärke der Glaskapillare 2 ist der Versiegelungsbereich 22 vergleichsweise klein, in Richtung parallel zur Längsachse L. Ebenso ist nur eine kurze Zeitdauer erforderlich, in der der Heizdraht 7 über einen elektrischen Stromfluss aktiviert wird. Da nur eine vergleichsweise geringe Wärmemenge zum Erzeugen der Versiegelung in dem Versiegelungsbereich 22 erforderlich ist, ist der Leuchtstoff 3 nur geringen thermischen Belastungen ausgesetzt. Hierdurch ist auch ein besonders kleiner Abstand zwischen dem Versiegelungsbereich 22 und dem nächstgelegenen Leuchtstoff 3 erzielbar. Dieser Abstand liegt bevorzugt bei 1 mm oder weniger.

Abweichend von der Darstellung in Figur 1C ist es optional möglich, dass sich außerhalb des Versiegelungsbereichs 22 an oder nahe einer äußeren Begrenzungsfläche der Glaskapillare 2 eine Kühlvorrichtung befindet. Über eine solche Kühlvorrichtung kann Wärme von dem Glasmaterial außerhalb des Versiegelungsbereichs 22 effizient abgeführt werden. Eine solche Kühlvorrichtung ist bevorzugt auch undurchlässig für Infrarotstrahlung, so dass vom Heizdraht 7 ausgehend kein Strahlungswärmeeintrag in die Glaskapillare 2 außerhalb des Versiegelungsbereiches 22 oder in den Leuchtstoff 3 erfolgt. Eine solche nicht gezeichnete Kühlvorrichtung ist bevorzugt auch in allen anderen Ausführungsbeispielen vorhanden.

Ferner ist es anders als gezeichnet optional möglich, dass beim Erzeugen des Versiegelungsbereichs 22 die Glaskapillare 2 lokal zusammengedrückt wird und/oder dass die sich beiderseits des Versiegelungsbereichs 22 befindlichen Teile der Glaskapillare 2 gegeneinander verdrillt werden. Auch hierzu kann an die Glaskapillare 2 nahe dem Versiegelungsbereich 22 eine Kühlvorrichtung angebracht sein.

Ebenso abweichend von der Darstellung in Figur 1 ist es möglich, dass sich der Versiegelungsbereich 22 an einem äußeren Rand befindet und nicht in einem mittleren Abschnitt der Glaskapillare 2, gesehen entlang der Längsachse L. Beispielsweise wird die Glaskapillare 2 dann lediglich an zwei einander gegenüberliegenden Enden versiegelt.

Im Verfahrensschritt der Figur 1D ist gezeigt, dass das im Schritt der Figur 1C gebildete Konversionselement 10 auf einen Streifen 40 aufgebracht wird. Der Streifen 40 umfasst mehrere Leuchtdiodenchips 4, die im Betrieb eine Primärstrahlung P, bevorzugt blaues Licht, emittieren. Die Leuchtdiodenchips 4 sind beispielsweise über Leiterbahnen oder über eine Leiterplatte des Streifens 40 elektrisch miteinander verbunden.

Durch den Leuchtstoff 3 im Inneren der Glaskapillare 2 wird nur ein Teil der Primärstrahlung P absorbiert und in eine Sekundärstrahlung S umgewandelt. Auf diese Weise kann das Halbleiterbauteil 1 beispielsweise weißes Licht emittieren.

Eine Länge des Halbleiterbauteils 1 entlang der Längsachse L liegt beispielsweise bei mindestens 5 cm oder 10 cm und/oder bei höchstens 30 cm oder 20 cm. Es kann sich bei dem Halbleiterbauteil 1 um eine streifenförmige Lichtquelle zur Hinterleuchtung von Displays in Kombination mit einem nicht dargestellten Flächenlichtleiter handeln.

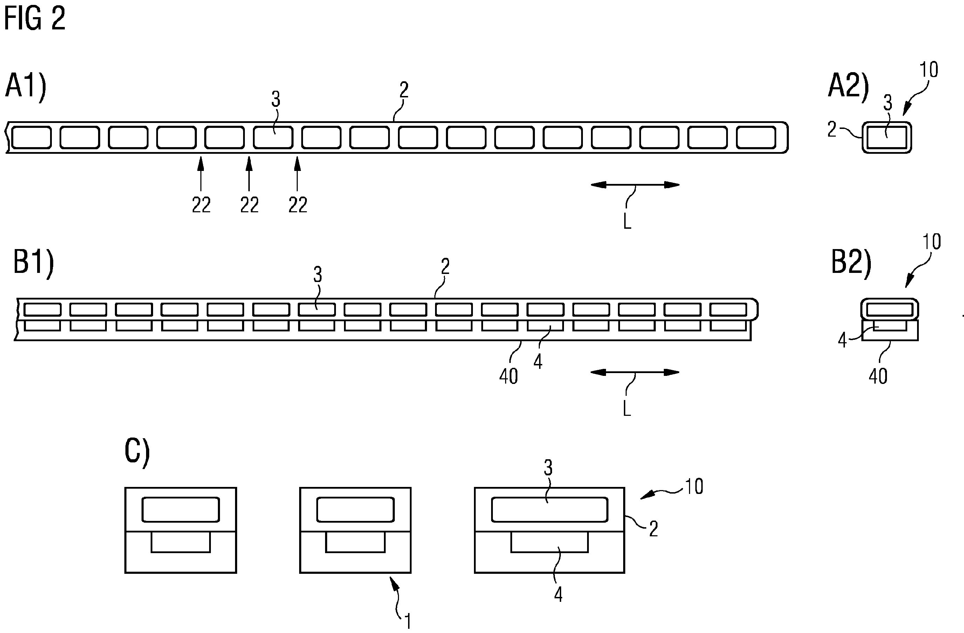

Gemäß Figur 2 sind mehrere Versiegelungsbereiche 22 vorhanden, zwischen denen sich jeweils ein Leuchtstoff 3 befindet, siehe die Schnittdarstellung entlang der Längsachse L in Figur 2A1 und die Querschnittsdarstellung in Figur 2A2.

Dieses Konversionselement 10 mit den mehreren Kammern wird anschließend auf den Streifen 40 mit den Leuchtdiodenchips 4 aufgebracht, siehe die Figuren 2B1 und 2B2. Dabei ist jedem der Leuchtdiodenchips 4 genau eine der Kammern mit dem Leuchtstoff 3 zugeordnet.

In Figur 2C ist zu sehen, dass der Streifen, 40 mit der Glaskapillare 2 zu den einzelnen Halbleiterbauteilen 1 vereinzelt wird, beispielsweise durch ein Sägen, ein Brechen in Kombination mit einem Ritzen oder durch ein Lasertrennen. Das Vereinzeln zu den Halbleiterbauteilen 1 erfolgt dabei in den Versiegelungsbereichen 22, wobei die Versiegelung der Kammern mit dem Leuchtstoff 3 jeweils intakt bleibt. Jedes der Halbleiterbauteile 1 umfasst gemäß Figur 2C genau einen der Leuchtdiodenchips 4, abweichend hiervon können aber auch mehrere der Leuchtdiodenchips 4 in den fertigen Halbleiterbauteilen 1 vorhanden sein.

Die Kammern mit dem Leuchtstoff 3 überdecken bevorzugt je den zugehörigen Leuchtdiodenchip 4 vollständig, in Draufsicht gesehen. Hierdurch ist sicherstellbar, dass der komplette Leuchtdiodenchip 4 von dem Leuchtstoff 3 überdeckt ist und homogen beispielsweise weißes Licht emittiert. Laterale Abmessungen des Konversionselements 10 sind bevorzugt gleich lateralen Abmessungen eines Gehäuses für die Leuchtdiodenchips 4. Somit erfolgt durch das Konversionselement 10 keine Vergrößerung einer lateralen Ausdehnung.

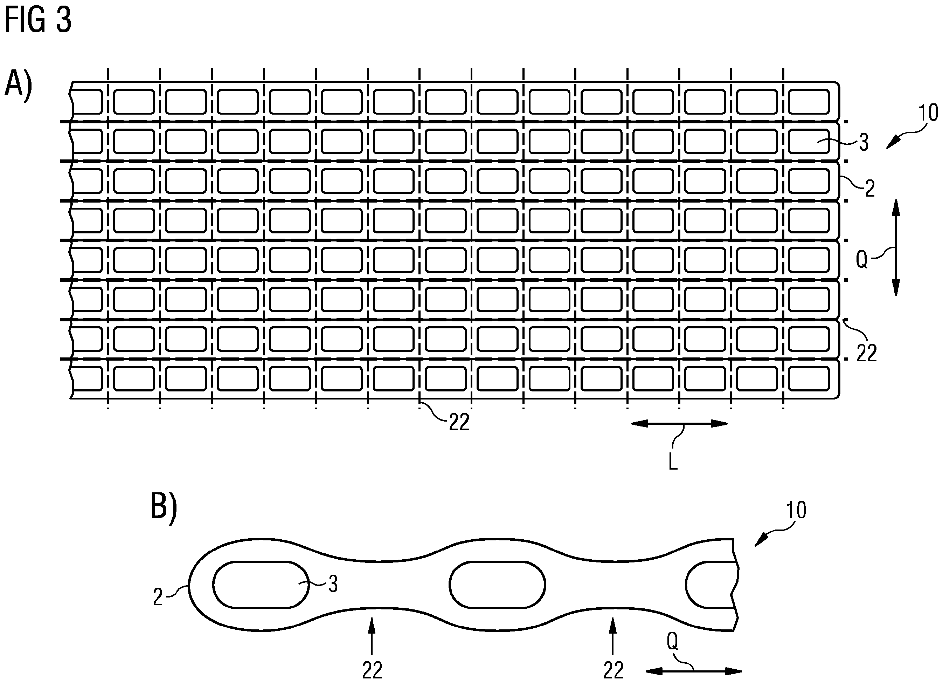

In Figur 3 ist ein Konversionselement 10 illustriert. Bei der Glaskapillare 2 handelt es sich vor der Versiegelung um ein Rechteckrohr mit einem langgezogenen, rechteckigen Querschnitt. Die Versiegelungsbereiche 22 erstrecken sich sowohl entlang der Längsachse L als auch entlang einer Querachse Q, senkrecht zur Längsachse L. In der Draufsicht der Figur 3A sind die Versiegelungsbereiche 22 durch Strichlinien symbolisiert. In Figur 3B ist eine Querschnittsdarstellung gezeigt.

Durch eine solche Glaskapillare 2 ist eine zweidimensionale Anordnung von Bereichen mit dem Leuchtstoff 3 realisierbar. Eine solche zweidimensionale Anordnung der Bereiche mit dem Leuchtstoff 3 kann auf ein zweidimensionales Feld von Leuchtdiodenchips 4 aufgebracht werden, nicht gezeichnet. Alternativ kann das Konversionselement 10 auch entlang der Versiegelungsbereiche 22 vereinzelt werden, analog zu Figur 2C.

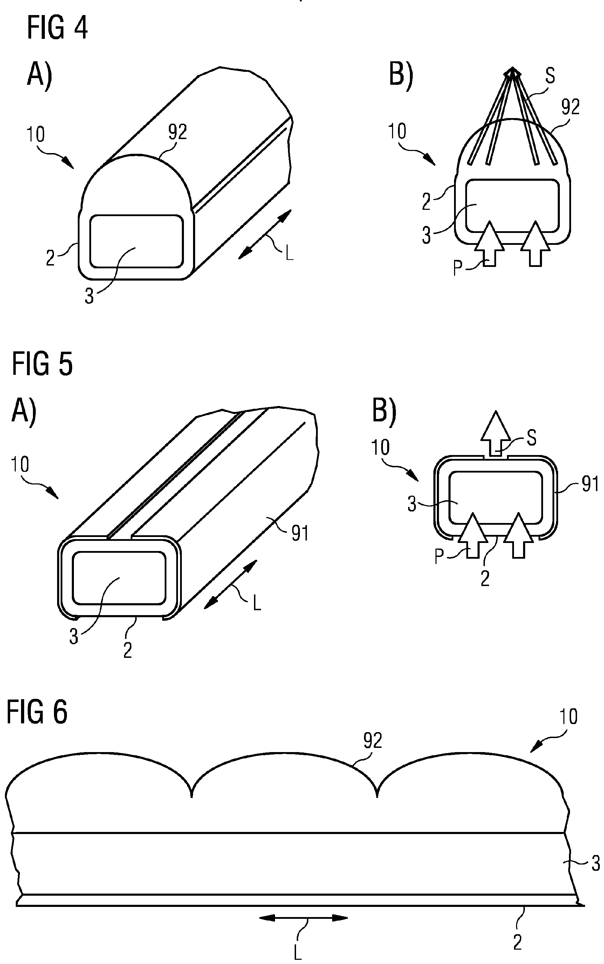

In den Figuren 4 bis 6 sind weitere Konversionselemente 10 gezeigt. Gemäß Figur 4, siehe die perspektivische Darstellung in Figur 4A und die Schnittdarstellung in Figur 4B, weist die Glaskapillare 2 ein optisches Element 92 auf. Das optische Element 92 ist als Sammellinse gestaltet, die sich gleichbleibend entlang der Längsachse L erstreckt. Eine der Linse 92 gegenüberliegende Seite der Glaskapillare 2 ist flach gestaltet und dazu eingerichtet, dass die Leuchtdiodenchips 4 hieran angebracht werden. Wie in Figur 4B veranschaulicht, ist durch eine solche Linse 92 eine Strahlformung etwa der Sekundärstrahlung S erzielbar.

In Figur 5 ist stellenweise auf eine Außenfläche der Glaskapillare 2 eine lichtundurchlässige, reflektierende oder auch absorbierende Beschichtung 91 aufgebracht. Die Beschichtung 91 ist beispielsweise aus einem oder mehreren Metallen gebildet.

An einer Unterseite, an der die Leuchtdiodenchips 4 zur Montage vorgesehen sind, ist an der Glaskapillare 2 keine Beschichtung aufgebracht. An einer Oberseite ist streifenförmig ein Bereich freigelassen, um die Sekundärstrahlung S und/oder Reste der Primärstrahlung P aus der Glaskapillare 2 heraustreten zu lassen.

Die Beschichtung 91 oder das optische Element 92 der Figuren 4 und 5 erstrecken sich gleichbleibend entlang der Längsachse L. In Figur 6 ist in einer Schnittdarstellung abweichend hiervon gezeigt, dass auch entlang der Längsachse L einzelne Linsen oder optische Elemente 92 geformt sein können. Entsprechendes ist ebenso hinsichtlich der Beschichtung 91 aus Figur 5 möglich.

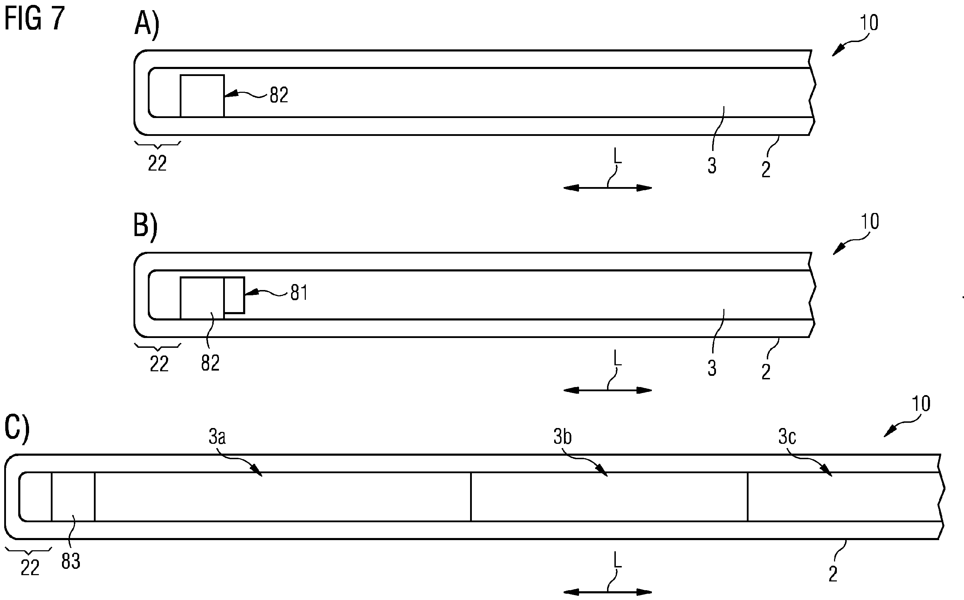

In Figur 7 sind weitere Schnittdarstellungen von Konversionselementen 10 gezeigt. Hierbei ist zur Vereinfachung der Darstellung jeweils nur ein Versiegelungsbereich 22 an einem Ende der Glaskapillare 2 gezeigt. Auch im Zusammenhang mit Figur 7 können Versiegelungsbereiche und Geometrien der Glaskapillare 2 vorliegen, wie in Verbindung mit den Figuren 1 bis 6 gezeigt, bevorzugt wie in Verbindung mit den Figuren 2 oder 3 erläutert.

Gemäß Figur 7A befindet sich an einem Ende der Glaskapillare 2 nahe an dem Versiegelungsbereich 22 ein Einfangmaterial 82, auch als Getter bezeichnet. Über das Einfangmaterial 82 ist Feuchtigkeit oder Sauerstoff aus dem restlichen Volumen der Glaskapillare 2 entfernbar.

Gemäß Figur 7B befindet sich ein Indikatormaterial 81 in der Glaskapillare 2. Über das Indikatormaterial 81 ist erkennbar, ob sich Sauerstoff oder Feuchtigkeit in der Glaskapillare 2 befindet und/oder ob eine zulässige, maximale Verarbeitungstemperatur beim Erzeugen des Versiegelungsbereichs 22 eingehalten wurde. Ein solches Indikatormaterial 81 kann auch in Kombination mit einem Einfangmaterial 82 vorliegen.

Ebenso kann, alternativ zu dem Einfangmaterial 82 oder dem Indikatormaterial 81, ein Isolierelement 83 nahe dem Versiegelungsbereich 22 in die Glaskapillare 2 eingebracht werden, siehe Figur 7C. Das Isolierelement 83 ist bevorzugt thermisch isolierend und kann lichtundurchlässig sein. Hierdurch ist der Leuchtstoff 3 beim Erzeugen des Versiegelungsbereichs 22 besser vor Überhitzung schützbar.

Das Isolierelement 83 ist bevorzugt aus einem Feststoff, alternativ aus einer Flüssigkeit, gebildet und bevorzugt in einem Abstand von höchstens 1 mm oder 0,5 mm zu dem Versiegelungsbereich 22 oder direkt an dem Versiegelungsbereich 22 in die Glaskapillare 2 eingebracht. Bevorzugt dichtet das Isolierelement 83 die Glaskapillare 2 ab, sodass sich das Isolierelement 83 über den gesamten Innenbereich der Glaskapillare 2 erstreckt, im Querschnitt gesehen. Eine spezifische Wärmeleitfähigkeit des Materials des Isolierelements 83 liegt bevorzugt bei höchstens 0,5 W/K•m oder 0,2 W/K•m oder 0,05 W/K•m.

Ferner sind in die Glaskapillare 2 drei verschiedene Leuchtstoffe 3a, 3b, 3c mit unterschiedlichen Emissionseigenschaften eingebracht, die entlang der Längsachse L unmittelbar aufeinanderfolgen. Zum Beispiel erzeugen die Leuchtstoffe 3a, 3b, 3c blaues, grünes und rotes Licht, etwa nach Anregung mit Primärstrahlung aus dem nahen ultravioletten Spektralbereich oder nach Anregung mit blauem Licht, zum Beispiel mit einer Dominanzwellenlänge von 450 nm, etwa mit einer Toleranz von 5 nm. Es ist dabei möglich, dass der Leuchtstoff 3a in direktem Kontakt zu dem Isolierelement 83 steht. Die Leuchtstoffe 3a, 3b, 3c sind voneinander beabstandet. Mehrere Leuchtstoffe sind auch in allen anderen Ausführungsbeispielen vorhanden.

### Bezugszeichenliste

- 1: lichtemittierendes Halbleiterbauteil
- 2: Glaskapillare
- 22: Versieglungsbereich
- 3: Leuchtstoff
- 32: Matrixmaterial
- 4: Leuchtdiodenchip
- 40: Streifen
- 5: Spritze
- 6: Schutzgas
- 7: elektrischer Heizdraht
- 81: Indikator
- 82: Einfangmaterial
- 83: Isolierelement
- 91: lichtundurchlässige, reflektierende Beschichtung
- 92: optisches Element
- 10: Konversionselement

- a: Kontaktwinkel
- L: Längsachse
- P: Primärstrahlung
- Q: Querachse
- S: Sekundärstrahlung

## Patentansprüche

1. Verfahren zur Herstellung von lichtemittierenden Halbleiterbauteilen (1) mit den Schritten:
A) Bereitstellen zumindest einer Glaskapillare (2) aus einem Glasmaterial,
B) Befüllen der Glaskapillare (2) mit mehreren verschiedenen Leuchtstoffen (3),
C) Versiegeln der Glaskapillare (2) in einem Versieglungsbereich (22) durch Aufschmelzen und/oder Erweichen des Glasmaterials, sodass die Glaskapillare (2) durch das Glasmaterial selbst verschlossen wird, und
D) Anbringen mindestens eines Teils der versiegelten Glaskapillare (2) an wenigstens einen Leuchtdiodenchip (4), sodass im Betrieb die von dem Leuchtdiodenchip (4) emittierte Strahlung durch die Leuchtstoffe (3) teilweise oder vollständig in Licht einer größeren Wellenlänge umgewandelt wird,
wobei im Schritt C) ein Abstand zwischen dem Versieglungsbereich (22) und den Leuchtstoffen (3) bei höchstens 4 mm liegt,
wobei die verschiedenen Leuchtstoffe (3) entlang einer Längsachse (L) der Glaskapillare (2) voneinander getrennt vorliegen, und
wobei die Leuchtstoffe (3) mit einer Spritze (5) in die Glaskapillare (2) eingespritzt werden, sodass sich in der Glaskapillare (2) nach dem Schritt B) mit den Leuchtstoffen (3) gefüllte Bereiche und mit einem Schutzgas (6) gefüllte Bereiche einander abwechseln.

2. Verfahren nach dem vorhergehenden Anspruch,
bei dem die Glaskapillare (2) vor dem Schritt C) eine mittlere Wandstärke von mindestens 20 µm und von höchstens 125 µm aufweist,
wobei eine Dauer des Verfahrensschritts C) pro Versiegelungsbereich (22) bei höchstens 4 s liegt, und wobei es sich bei den Leuchtstoffen (3) um Quantenpunkte und/oder um organische Moleküle handelt.

3. Verfahren nach einem der vorhergehenden Ansprüche,
bei dem sich im Schritt B) die Leuchtstoffe (3) in einem flüssigen Matrixmaterial (32) befindet, das in die Glaskapillare (2) eingebracht wird,
wobei das Matrixmaterial (32) nachfolgend photochemisch oder thermisch ausgehärtet wird.

4. Verfahren nach dem vorhergehenden Anspruch,
bei dem das Matrixmaterial (32) im Schritt B) einen Kontaktwinkel (a) zur der Glaskapillare (2) von mindestens 65° und von höchstens 105° aufzeigt,
wobei ein Quotient aus einer Länge der Glaskapillare (2) und einem Durchmesser der Glaskapillare (2) bei mindestens 15 und bei höchstens 150 liegt.

5. Verfahren nach einem der vorhergehenden Ansprüche,
bei dem das Glasmaterial ein lichtdurchlässiges Borsilikatglas mit Masseanteilen von mindestens 70 % Siliziumdioxid und mindestens 7 % Bortrioxid ist, wobei eine Verarbeitungstemperatur des Glasmaterials im Schritt C) bei mindestens 500 °C und höchstens 900 °C liegt,
wobei im Schritt C) die Glaskapillare (2) als mechanisch selbsttragende Einheit erhalten bleibt, sodass im Schritt C) kein Vereinzeln oder Abschmelzen erfolgt.

6. Verfahren nach einem der Ansprüche 1 bis 4,
bei dem das Glasmaterial ein niederschmelzendes Glas ist und eine Verarbeitungstemperatur des Glasmaterials im Schritt C) bei mindestens 200 °C und höchstens 500 °C liegt.

7. Verfahren nach einem der vorhergehenden Ansprüche,
bei dem vor dem Schritt C) eine mittlere Querschnittsfläche eines Innenraums der Glaskapillare (2) bei mindestens 0,2 mm x 0,3 mm und bei höchstens 1,5 mm x 0,8 mm liegt,
wobei die Querschnittsfläche ein Rechteck oder ein Rechteck mit abgerundeten Ecken ist.

8. Verfahren nach einem der vorhergehenden Ansprüche,
bei dem das Aufschmelzen im Schritt C) mit mindestens einem externen, außerhalb der Glaskapillare (2) liegenden elektrischen Heizdraht (7) erfolgt.

9. Verfahren nach einem der vorhergehenden Ansprüche,
bei dem die Glaskapillare (2), im Querschnitt gesehen, mehrere nebeneinanderliegende Innenräume aufweist, die jeweils mit den Leuchtstoffen (3) befüllt werden.

10. Verfahren nach einem der vorhergehenden Ansprüche,
bei dem in die Glaskapillare (2) genau drei verschiedene Leuchtstoffe (3a, 3b, 3c) mit unterschiedlichen Emissionseigenschaften eingebracht werden,
wobei die Leuchtstoffe (3a, 3b, 3c) unabhängig voneinander blaues, grünes und rotes Licht erzeugen, nach Anregung mit einer Primärstrahlung aus dem nahen ultravioletten Spektralbereich oder nach Anregung mit blauem Licht,
wobei in einem Abstand von höchstens 0,5 mm zu dem Versiegelungsbereich (22) ein Isolierelement (83) in die Glaskapillare (2) eingebracht wird und das Isolierelement (83) thermisch isolierend und lichtundurchlässig ist, sodass die Leuchtstoffe beim Erzeugen des Versiegelungsbereichs (22) vor Überhitzung geschützt sind, und
wobei einer der Leuchtstoffe in direktem Kontakt zu dem Isolierelement (83) steht.

11. Verfahren nach einem der vorhergehenden Ansprüche, ferner umfassend einen Schritt E), in dem die Glaskapillare (2) zu Konversionselementen (10) vereinzelt wird,
wobei der Schritt E) dem Schritt C) und/oder dem Schritt D) nachfolgt.

12. Verfahren nach dem vorhergehenden Anspruch,
bei dem entlang der Längsachse (L) mehrere der Versieglungsbereiche (22) vorhanden sind und sich zwischen zumindest einigen benachbarten Versieglungsbereichen (22) je ein Teil der Leuchtstoffe (3) befindet,
wobei in zumindest einigen der Versiegelungsbereiche (22) die Vereinzelung im Schritt E) erfolgt.

13. Verfahren nach dem vorhergehenden Anspruch,
bei dem sowohl entlang der Längsrichtung (L) als auch entlang einer Querachse (Q) mehrere der Vereinzelungsbereiche (22) vorhanden sind, sodass durch eine zweidimensionale Anordnung von Bereichen mit den Leuchtstoffen (3) vorliegt,
wobei auf diese zweidimensionale Anordnung im Schritt D) ein zweidimensionales Feld von Leuchtdiodenchips (4) aufgebracht wird.

14. Verfahren nach einem der vorhergehenden Ansprüche,
bei dem im Schritt B) in die Glaskapillare (2) zumindest ein Indikator (81) für wenigstens eine der Größen Feuchtegehalt, Sauerstoffgehalt und Maximaltemperatur und alternativ oder zusätzlich zumindest ein Einfangmaterial (82) für Sauerstoff oder Feuchtigkeit eingebracht wird.

15. Verfahren nach einem der vorhergehenden Ansprüche,
bei dem außen auf die Glaskapillare (2) stellenweise eine lichtundurchlässige, reflektierende Beschichtung (91) aufgebracht und/oder bei dem die Glaskapïllare (2) zumindest bereichsweise als optisches Element (92) geformt ist.

## Claims

1. A method for producing light-emitting semiconductor components (1), comprising the following steps:
A) providing at least one glass capillary (2) made of a glass material,
B) filling the glass capillary (2) with a plurality of different phosphors (3),
C) sealing the glass capillary (2) in a sealing region (22) by melting and/or softening the glass material such that the glass capillary (2) is closed by the glass material itself, and
D) attaching at least one part of the sealed glass capillary (2) to at least one light-emitting diode chip such that, during operation, the radiation emitted by the light-emitting diode chip (4) is partially or completely converted into light of a greater wavelength by the phosphors (3),
wherein, in step C), a distance between the sealing region (22) and the phosphors (3) is at most 4 mm,
wherein the different phosphors (3) are present separately from one another along a longitudinal axis (L) of the glass capillary (2), and
wherein the phosphors (3) are injected with a syringe (5) into the glass capillary (2) such that regions filled with the phosphors (3) and regions filled with a protective gas (6) alternate with one another in the glass capillary (2) after step B).

2. The method according to the preceding claim,
in which the glass capillary (2) has an average wall thickness of at least 20 µm and of at most 125 µm before step C) ,
wherein a duration of the method step C) per sealing region (22) is at most 4 s, and
wherein the phosphors (3) are quantum dots and/or organic molecules.

3. The method according to one of the preceding claims,
in which, in step B), the phosphors (3) are located in a liquid matrix material (32) which is introduced into the glass capillary (2),
wherein the matrix material (32) is subsequently photochemically or thermally cured.

4. The method according to the preceding claim,
in which the matrix material (32) in step B) exhibits a contact angle (a) to the glass capillary (2) of at least 65° and of at most 105°,
wherein a quotient of a length of the glass capillary (2) and a diameter of the glass capillary (2) is at least 15 and at most 150.

5. The method according to one of the preceding claims,
in which the glass material is a light-permeable borosilicate glass having mass fractions of at least 70% silicon dioxide and of at least 7% boron trioxide,
wherein a processing temperature of the glass material in step C) is at least 500°C and at most 900°C,
wherein in step C) the glass capillary (2) is retained as a mechanically self-supporting unit, such that no separation or melting takes place in step C).

6. The method according to any one of claims 1 to 4,
wherein the glass material is a low-melting glass and a processing temperature of the glass material in step C) is at least 200°C and at most 500°C.

7. The method according to one of the preceding claims,
in which, before step C), an average cross-sectional area of an interior of the glass capillary (2) is at least 0.2 mm x 0.3 mm and at most 1.5 mm x 0.8 mm,
wherein the cross-sectional area is a rectangle or a rectangle with rounded corners.

8. The method according to one of the preceding claims,
in which the melting in step C) takes place with at least one external electrical heating wire (7) lying outside the glass capillary (2).

9. The method according to one of the preceding claims,
in which the glass capillary (2), viewed in cross-section, has a plurality of adjacent inner spaces which are each filled with the phosphors (3).

10. The method according to one of the preceding claims,
in which precisely three different phosphors (3a, 3b, 3c) having different emission properties are introduced into the glass capillary (2),
wherein the phosphors (3a, 3b, 3c) independently of one another generate blue, green and red light, after excitation with a primary radiation from the near ultraviolet spectral region or after excitation with blue light,
wherein an insulating element (83) is introduced into the glass capillary (2) at a distance of at most 0.5 mm from the sealing region (22), and the insulating element (83) is thermally insulating and opaque such that the phosphors are protected from overheating when the sealing region (22) is produced, and
wherein one of the phosphors is in direct contact with the insulating element (83).

11. The method according to one of the preceding claims, furthermore comprising a step E) in which the glass capillary (2) is separated into conversion elements (10),
wherein step E) follows step C) and/or step D).

12. The method according to the preceding claim,
in which a plurality of the sealing regions (22) are present along the longitudinal axis (L) and in each case a part of the phosphors is located between at least some adjacent sealing regions (22),
wherein the separation in step E) takes place in at least some of the sealing regions (22).

13. The method according to the preceding claim,
in which a plurality of the separating regions (22) are present both along the longitudinal direction (L) and along a transverse axis (Q), such that a two-dimensional arrangement of regions with the phosphors (3) is present,
wherein a two-dimensional field of light-emitting diode chips (4) is applied to this two-dimensional arrangement in step D) .

14. The method according to one of the preceding claims,
in which, in step B), at least one indicator (81) for at least one of the variables moisture content, oxygen content and maximum temperature and alternatively or additionally at least one trapping material for oxygen or moisture is introduced into the glass capillary (2).

15. The method according to one of the preceding claims, in which an opaque, reflective coating (91) is applied in places on an outside of the glass capillary (2) and/or in which the glass capillary (2) is shaped at least in some regions as an optical element (92).

## Revendications

1. Un procédé de fabrication de composants semi-conducteurs électroluminescents (1), comprenant les étapes suivantes:
A) fournir au moins un capillaire en verre (2) constitué d'un matériau en verre,
B) remplir le capillaire de verre (2) avec une pluralité de luminophores (3) différents,
C) sceller le capillaire en verre (2) dans une région d'étanchéité (22) par fusion et/ou ramollissement du matériau en verre de telle sorte que le capillaire en verre (2) est fermé par le matériau en verre lui-même, et
D) fixer au moins une partie du capillaire de verre scellé (2) à au moins une puce de diode électroluminescente (4) de telle sorte que, pendant le fonctionnement, le rayonnement émis par la puce de diode électroluminescente (4) est partiellement ou complètement converti en lumière d'une longueur d'onde supérieure par les luminophores (3),
dans l'étape C), une distance entre la région d'étanchéité (22) et les luminophores (3) est d'au plus 4 mm,
les différents luminophores (3) étant présents séparément les uns des autres le long d'un axe longitudinal (L) du capillaire en verre (2), et
les luminophores (3) sont injectés avec une seringue (5) dans le capillaire de verre (2) de sorte que les zones remplies avec les luminophores (3) et les zones remplies d'un gaz protecteur (6) alternent les unes avec les autres dans le capillaire de verre (2) après l'étape B).

2. Le procédé selon la revendication précédente,
dans lequel le capillaire en verre (2) a une épaisseur de paroi moyenne d'au moins 20 µm et d'au plus 125 µm avant l'étape C),
une durée de l'étape C) de procédé par région d'étanchéité (22) étant d'au plus 4 s, et
les phosphores (3) sont des points quantiques et/ou des molécules organiques.

3. Le procédé selon l'une des revendications précédentes,
dans l'étape B), les luminophores (3) sont placés dans un matériau de matrice (32) liquide qui est introduit dans le capillaire de verre (2),
le matériau matrice (32) est ensuite photochimiquement ou thermiquement durci.

4. Le procédé selon la revendication précédente,
dans laquelle le matériau de matrice (32) à l'étape B) présente un angle de contact (a) sur le capillaire de verre (2) d'au moins 65° et d'au plus 105°,
un quotient d'une longueur du capillaire en verre (2) et d'un diamètre du capillaire en verre (2) est d'au moins 15 et au plus 150.

5. Le procédé selon l'une des revendications précédentes,
le matériau de verre est un verre de borosilicate perméable à la lumière ayant des fractions de masse d'au moins 70% de dioxyde de silicium et d'au moins 7% de trioxyde de bore,
une température de traitement du matériau de verre dans l'étape C) étant d'au moins 500°C et d'au plus 900°C,
dans l'étape C), le capillaire en verre (2) est retenu sous la forme d'une unité autosupportée mécaniquement, de telle sorte qu'aucune séparation ou fusion n'a lieu à l'étape C).

6. Le procédé selon l'une quelconque des revendications 1 à 4,
le matériau de verre étant un verre à bas point de fusion et
une température de traitement du matériau de verre dans l'étape C) étant d'au moins 200°C et d'au plus 500°C.

7. Le procédé selon l'une des revendications précédentes,
dans lequel, avant l'étape C), une aire de section transversale moyenne d'un intérieur du capillaire en verre (2) est d'au moins 0,2 mm x 0,3 mm et d'au plus 1,5 mm x 0,8 mm,
la surface de section transversale est un rectangle ou un rectangle avec des coins arrondis.

8. Le procédé selon l'une des revendications précédentes,
dans lequel la fusion à l'étape C) a lieu avec au moins un fil chauffant électrique externe (7) situé à l'extérieur du capillaire en verre (2).

9. Le procédé selon l'une des revendications précédentes,
dans lequel le capillaire en verre (2), vu en coupe transversale, présente une pluralité d'espaces internes adjacents qui sont chacun remplis avec les luminophores (3).

10. Le procédé selon l'une des revendications précédentes,
dans lequel exactement trois luminophores (3a, 3b, 3c) différents présentant des propriétés d'émission différentes sont introduits dans le capillaire de verre (2),
les luminophores (3a, 3b, 3c) indépendamment les uns des autres génèrent de la lumière bleue, verte et rouge, après excitation avec un rayonnement primaire provenant de la région spectrale proche de l'ultraviolet ou après excitation avec une lumière bleue,
un élément isolant (83) est introduit dans le capillaire de verre (2) à une distance d'au plus 0,5 mm de la zone d'étanchéité (22), et l'élément isolant (83) est thermiquement isolant et opaque de sorte que les luminophores sont protégés contre une surchauffe lorsque la zone d'étanchéité (22) est produite, et
l'un des luminophores étant en contact direct avec l'élément isolant (83).

11. Le procédé selon l'une des revendications précédentes, comprenant une étape E) dans laquelle le capillaire en verre (2) est séparé en éléments de conversion (10),
l'étape E) suit l'étape C) et/ou l'étape D).

12. Le procédé selon la revendication précédente,
une pluralité de régions d'étanchéité (22) sont présentes le long de l'axe longitudinal (L) et, dans chaque cas, une partie des luminophores est située entre au moins certaines régions d'étanchéité adjacentes (22),
la séparation à l'étape E) a lieu dans au moins une partie des zones d'étanchéité (22).

13. Le procédé selon la revendication précédente,
dans lequel une pluralité de régions de séparation (22) sont présentes à la fois le long de la direction longitudinale (L) et le long d'un axe transversal (Q), de telle sorte qu'un agencement bidimensionnel de régions avec les luminophores (3) est présent,
un champ bidimensionnel de puces de diode électroluminescente (4) est appliqué à cet agencement bidimensionnel à l'étape D) .

14. Le procédé selon l'une des revendications précédentes,
dans l'étape B), au moins un indicateur (81) pour au moins une des variables: la teneur en humidité, la teneur en oxygène et la température maximale et, en variante ou en outre, au moins un matériau de piégeage pour l'oxygène ou l'humidité est introduit dans le capillaire en verre (2).

15. Le procédé selon l'une des revendications précédentes,
dans lequel un revêtement réfléchissant opaque (91) est appliqué à l'extérieur du capillaire en verre (2) et/ou dans lequel le capillaire en verre (2) est formé au moins par endroits sous la forme d'un élément optique (92).
